(19) 

Europäisches
Patentamt
European
Patent Office
Office européen
des brevets

(11)     EP 3 056 913 A1

(12)                          EUROPEAN PATENT APPLICATION

(43) Date of publication:
    17.08.2016  Bulletin 2016/33

(51) Int Cl.:
    *G01R 21/00* (2006.01)          *G01R 27/26* (2006.01)
    *G01R 31/12* (2006.01)

(21) Application number: 16150588.8

(22) Date of filing: 08.01.2016

(84) Designated Contracting States:
    AL AT BE BG CH CY CZ DE DK EE ES FI FR GB
    GR HR HU IE IS IT LI LT LU LV MC MK MT NL NO
    PL PT RO RS SE SI SK SM TR
    Designated Extension States:
    BA ME
    Designated Validation States:
    MA MD

(30) Priority:  09.01.2015  US 201514593596

(71) Applicant: General Electric Company
    Schenectady, NY 12345 (US)

(72) Inventor: COSTA I BRICHA, Elm
    Lisburn, Antrim BT28 2RF (GB)

(74) Representative: Cleary, Fidelma
    GPO Europe
    GE International Inc.
    The Ark
    201 Talgarth Road
    Hammersmith
    London W6 8BJ (GB)

(54) USE OF VOLTAGE PROBE TO MEASURE HIGH VOLTAGE AMPLITUDE AND PHASE TO IMPROVE ON-LINE BUSHING MONITORING RELEVANCE

(57)     A bushing system includes a bushing monitor (56) configured to monitor on-line operation of a capacitive-core bushing (10) with a test tap. The bushing monitor includes a processor (58) operatively coupled to a memory (60). The processor (58) is configured to access a voltage signal received indicating a measured voltage amplitude or phase (70) of the bushing (10). The processor (58) is configured to access a current signal received indicating a measured current amplitude or phase (68) of the bushing (10). The processor (58) is configured to determine a capacitance value and/or a power factor value (72) of the bushing (10) based on the measured voltage and the measured current values, and generate a resultant signal or output based on the capacitance value and/or the power factor value (72) of the bushing (10)

FIG. 3

EP 3 056 913 A1

**Description**

BACKGROUND

The subject matter disclosed herein relates generally to transformer monitoring. More specifically, the present disclosure relates to bushing monitoring on power transformers.

Power systems use a variety of components to send power to homes, industries, and the like. Transformers in power systems allow economical transmission of power and distribution through transmission lines. Transformers are used to transfer energy from one circuit to another, usually with a change in voltage. When transmitting power from a power generator through a transmission line to a home, losses in the transmission line correspond to the amount of current running through the transmission line. Accordingly, transformers are used to step up/down voltages. As losses are proportional to current, any given power transmission losses can be reduced by stepping up the voltage and therefore stepping down the current, where power is the product of voltage and current.

In many cases, bushings are used to insulate the main leads from each other and from the grounded transformer outer casing. However, failure of transformer bushings may cause power outages and/or damage to transformers. As such, improved monitoring of bushings can prevent damage to transformers and prevent outages.

A bushing that can be described electrically as a capacitor can then be defined by its capacitance and power factor. A bushing monitor can measure these two parameters by monitoring the relative amplitude and phase between the bushing leakage current and the main lead voltage.

BRIEF DESCRIPTION

Certain embodiments commensurate in scope with the originally claimed invention are summarized below. These embodiments are not intended to limit the scope of the claimed invention, but rather these embodiments are intended only to provide a brief summary of possible forms of the invention. Indeed, the invention may encompass a variety of forms that may be similar to or different from the embodiments set forth below.

In a first embodiment, a bushing system includes a bushing monitor configured to monitor on-line operation of a capacitive-core bushing with a test tap, wherein the bushing monitor includes a processor operatively coupled to a memory, wherein the processor is configured to access a voltage signal received indicating a measured voltage amplitude of the bushing, access a current signal received indicating a measured current amplitude of the bushing, determine a capacitance value of the bushing based on the measured voltage amplitude and the measured current amplitude, and generate a resultant signal or output based on the capacitance value of the bushing.

In a second embodiment, a bushing system includes a bushing monitor configured to monitor on-line operation of a capacitive-core with a test tap, wherein the bushing monitor includes a processor operatively coupled to a memory, wherein the processor is configured to access a voltage signal received indicating a measured voltage phase of the bushing, access a current signal received indicating a measured current phase of the bushing, determine a power factor value of the bushing based on the measured voltage phase and the measured current phase, and generate a resultant signal or output based on the power factor value of the bushing.

In a third embodiment, a method includes accessing, via a processor, signals received from a voltage sensor indicating a measured voltage amplitude and a measured voltage phase of a bushing during operation, accessing, via the processor, signals from a current sensor indicating a measured current amplitude and a measured current phase of the bushing, determining, via the processor, a capacitance value and a power factor value of the bushing, wherein the capacitance value is based on the measured voltage amplitude and the measured current amplitude, wherein the power factor value is based on the measured voltage phase and the measured current phase, and generating, via the processor, a resultant signal or output based on the capacitance value and the power factor value of the bushing.

BRIEF DESCRIPTION OF THE DRAWINGS

These and other features, aspects, and advantages of the present invention will become better understood when the following detailed description is read with reference to the accompanying drawings in which like characters represent like parts throughout the drawings, wherein:

FIG. 1 is a cross-sectional view of a bushing insulating a main lead from the interface this conductor passes through, in accordance with an embodiment of the present disclosure;

FIG. 2 is a circuit diagram and a graph of a simple model of a real capacitor and this model's current phasor, thus being a model of a capacitive core bushing of FIG. 1, in accordance with an embodiment of the present disclosure;

FIG. 3, is a schematic diagram of a bushing system with a bushing monitor to monitor the bushing of FIG. 1, in accordance with an embodiment of the present disclosure; and

FIG. 4 is a flow diagram of a process for the bushing monitor to monitor the bushing in FIG. 3, in accordance with an embodiment of the present disclosure.

DETAILED DESCRIPTION

One or more specific embodiments of the present invention will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present invention, the articles "a," "an," "the," and "said" are intended to mean that there are one or more of the elements. The terms "comprising," "including," and "having" are intended to be inclusive and mean that there may be additional elements other than the listed elements.

A bushing insulates the internal main lead from the interface the main lead goes through, and a bushing of a capacitive-core type can be modeled as a capacitor. As a bushing ages, it can ultimately fail. Further, bushings can fail due to random failure and infant mortality. Most high voltage bushings will be associated to transformers, and bushing failure may lead to the transformer's failure. Transformer bushing failure is responsible for a significant number of transformer outages, since when a bushing fails, it often causes damage or destroys the transformer or surrounding assets.

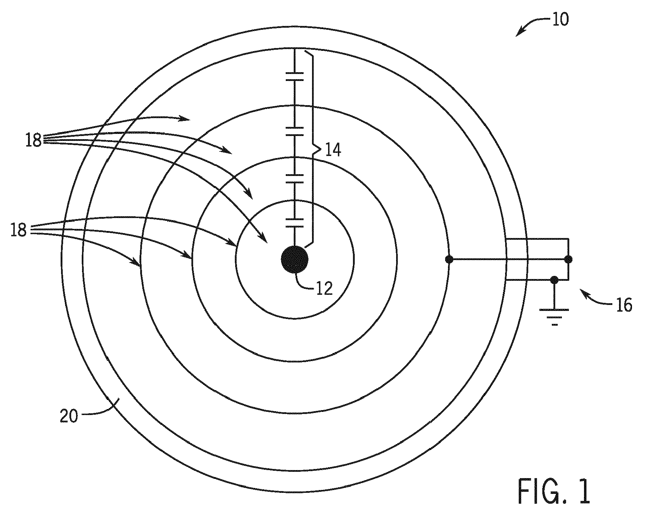

Accordingly, bushings may be monitored to diagnose and prevent problems from occurring, for instance, due to bushing aging. Bushing monitoring uses an equivalent capacitance and a power factor to assess the aging of the bushing. Off-line (e.g., when a power outage occurs) monitoring may allow monitoring of capacitance and power factor, but the monitoring performance is limited in preventing failures because these techniques are typically performed during power outages. Conversely, on-line bushing monitoring may be performed while the transformer is in service. However, it may be difficult to determine the health of the bushing during on-line monitoring. More specifically, relative changes of capacitance and power factor can be measured, but not the absolute capacitance and power factor per phase unless the voltage relative angle and amplitude per phase are known. Accordingly, a system and method of measuring voltage and current characteristics that can be used to determine the capacitance and/or power/dissipation factor of an on-line bushing is described herein. Turning now to the figures, FIG. 1 is a cross-sectional view of a bushing 10 insulating a conductor 12 (i.e. main lead). More particularly, the type of bushing 10 to be monitored is that with a capacitive core 14 and a test tap 16. The bushing 10 may include any number of layers 18 (e.g., 30-50 layers for high voltage bushings) suitable to protect and isolate the conductor 12. Electrically, the bushing 10 may be described as a capacitor between the main lead and the interface 20 it isolates the main lead from. As described above, bushing monitoring utilizes the capacitance and the power factor to assess the aging of the bushing 10.

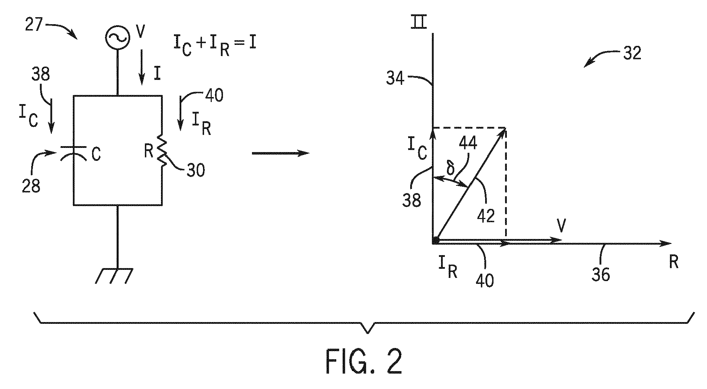

FIG. 2 is a circuit diagram of a simplified model 27 of the bushing 10 from FIG. 1 as well as a graph showing current versus voltage of the bushing 10. The circuit diagram of the bushing 10 includes a capacitor 28 and a resistor 30. The capacitor 28 may represent the equivalent capacitance across the layers 18. The resistor 30 is used to model resistive current. When determining capacitance, the resistor 30 may be considered irrelevant or ignored when compared to the capacitive contribution from the capacitor 28. Thus, the current through the capacitor 28 is given as:

$$I = C1 \frac{dV}{dt} \quad \text{equation (1)}.$$

The instantaneous voltage of the main lead is assumed to be sinusoidal:

$$V(t, \phi) = V_0 \sin(2\pi f t + \phi) \quad \text{equation (2)}.$$

In equation (2), the voltage amplitude is $V_0$. Combining equation (1) with the derivative of equation (2) is shown as:

$$I = 2\pi f C1 * V_0 \cos(2\pi f t + \phi) \text{ equation (3).}$$

The current amplitude from equation (3) is given as:

$$I = 2\pi f C1 * V_0 \quad \text{equation (4).}$$

By solving for C1 from equation (4), the capacitance may be determined by:

$$C1 = \frac{I}{2\pi f V_0} \quad \text{equation (5).}$$

From equation (5), the capacitance of the bushing 10 from FIG. 1 is based on the current amplitude and the voltage amplitude of the bushing 10. In other words, the capacitance is proportional to the current passing through the bushing 10 divided by the voltage of the bushing 10.

FIG. 2 also includes a graph 32 showing the leakage current phasor respect to the main lead voltage of the bushing 10 from FIG. 1. In an ideal capacitor, the current leads the voltage by 90 degrees. Thus, the current through the equivalent capacitor, or the capacitor current 38 (i.e. $I_C$), is shown on the current axis. In real applications, there is resistive current 40 (i.e. $I_R$) in the bushing 10, modeled with the resistor 30. The resistive current 40 is typically a small amount (e.g., < 1%), and has been exaggerated for illustrative purposes. In FIG. 2, the capacitive current 38 and resistive current 40 combine to form the leakage current 42.

As explained above, power factor may provide an indication of bushing health. Accordingly, power factor may be given as:

$$PF = \sin(\delta) \text{ equation (6)}$$

In equation (6), $\delta$ defines the capacitor's deviation from an ideal capacitor (i.e. $\delta$=0 for an ideal capacitor).

An alternative measurement may involve dissipation factor, which may be given as:

$$DF = \tan(\delta) \text{ equation (7)}$$

Using small-angle approximation, the dissipation factor and/or the power factor may be approximated using:

$$\tan(\delta) \approx \delta \text{ equation (8)}$$

$$\sin(\delta) \approx \delta \text{ equation (9)}$$

The small-angle approximation above requires that the angle units are in radians. The equations explained above may be used with measured voltages and currents from an on-line bushing monitor of a single bushing to calculate the capacitance and $\delta$. Further, $\delta$ can be used to determine the power factor, the dissipation factor, and is one of the two parameters characterizing the bushing 10 state/health. As illustrated in FIG. 2, $\delta$ 44 can be approximated (equation 8) as the ratio of the capacitive current 38 and the resistive current 40.

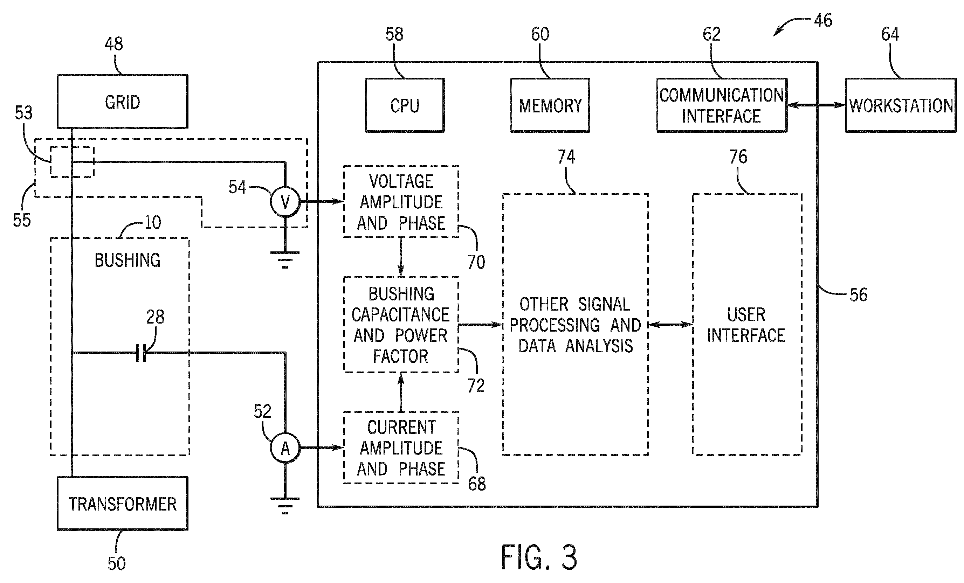

FIG. 3 is a schematic diagram of a bushing system 46 in accordance with an embodiment of the present disclosure. A generator of a power plant may supply power to the grid 48. The grid may supply power to a transformer 50. The line may include a capacitive core bushing 10 with a test tap 16. Similarly, the bushing 10 is modeled as the capacitor 28 in FIG 2. The system 46 includes a current sensor 52 (e.g., ammeter and/or ammeter probe) to measure the current amplitude and phase passing through bushing 10, and the system 46 includes a voltage sensor 54 (e.g., voltmeter and/or voltage probe) to measure the voltage amplitude and phase of the bushing 10. A case 53 may, for instance, be configured to connect (e.g., attach or detect at a distance) the voltage sensor 54 to the main lead, so that the voltage sensor 54 can provide accurate readings. As shown in FIG. 3, the case 53 (e.g., a magnetic case) may enclose the connection, or it may enclose the voltage sensor 54 as shown with enclosure 55. As shown in FIG. 3, the voltage sensor 54 is configured to transmit voltage signals indicating a measured voltage amplitude and phase (e.g., main lead voltage amplitude and phase) to a bushing monitor 56. Similarly, the current sensor 52 is configured to transmit current signals indicating a measured current amplitude and phase of the bushing 10. While the voltage sensor 54 and the current sensor 52 are shown in FIG. 3 as separate from the bushing monitor 56, the sensors may be included in the bushing monitor 56 (e.g., lines may be run from the transformer to sensors included in the bushing monitor 56), or any place suitable to provide voltage and current measurements. The leakage current amplitude and/or phase may be measured at the bushing test tap 16, and the voltage amplitude and/or phase may be measured from the main lead.

In an embodiment, the bushing monitor 56 may use a set of 3 bushings to operate with fewer measured values, namely without the voltage phase and amplitude. This may be performed, for instance, by calculating capacitance and/or power factor based on relative change with respect to other bushings by monitoring the leakage current of the bushing 10. Alternatively, an embodiment may monitor two bushings in series. However, these systems may be limited to systems that have multiple bushings (e.g., 2 bushings in series or 3 bushings for each phase of a 3 phase system). One of the advantages of an embodiment of the present disclosure may be the ability to monitor single bushings. The voltage reference may be used to reduce noise from monitoring a single bushing. The noise/systematic error reduction may come from measuring relative values (no voltage reference) to absolute values (with voltage reference).

The bushing monitor 56 may include a processor 58 or multiple processors, memory 60, and a communication interface 62. The processor 58 may be operatively coupled to the memory 60 to execute instructions for carrying out the presently disclosed techniques. These instructions may be encoded in programs or code stored in a tangible non-transitory computer-readable medium, such as the memory 60 and/or other storage. The processor 58 may be a general purpose processor, system-on-chip (SoC) device, or application-specific integrated circuit, or some other processor configuration.

Memory 60, in the embodiment, includes a computer readable medium, such as, without limitation, a hard disk drive, a solid state drive, a diskette, a flash drive, a compact disc, a digital video disc, random access memory (RAM), and/or any suitable storage device that enables processor 58 to store, retrieve, and/or execute instructions and/or data. Memory 60 may include one or more local and/or remote storage devices.

The bushing monitor 56 may have a wide variety of inputs and outputs in the communication interface 62. The communication interface 62 may include, without limitation, a network interface controller (NIC), a network adapter, a transceiver, and/or any suitable communication device that enables the bushing monitor 56 to operate as described herein. The communication interface 62 may connect to a network, to a remote workstation 64, and/or a database using any suitable communication protocol, such as, for example, a wired Ethernet protocol or a wireless Ethernet protocol. Additionally and/or alternatively, the communication interface 62 of the bushing monitor 56 may include inputs/outputs (e.g., ports or pins) that are configured to send/receive signals, such as voltage and/or current signals (e.g., without such communication protocols). The communication interface 62 may receive signals (e.g., via the inputs) indicating the measured current amplitude and phase 68 from the current sensor 52. Similarly, the communication interface 62 may receive signals (e.g., via the inputs) indicating the measured voltage amplitude and phase 70 from the voltage sensor 54. The processor 58 may access the measured voltage and current signals received. The processor 58 may then determine the capacitance and/or power factor 72 based on the measured voltage characteristics (e.g., voltage amplitude and phase 68) and current characteristics (e.g., voltage amplitude and phase 70) by using the methods described in conjunction with FIG. 2. While capacitance and power factor are shown in FIG. 3, other values based on the measured voltage amplitude and phase and current amplitude and phase may be calculated suitable for assessing the aging of the bushing. The processor 58 may perform other signal processing and data analysis 74. The processor 58 may then generate a resultant signal or output based on the capacitance and/or power factor 72. The resultant signal or output may be an analog and/or digital signal or output. The bushing monitor 56 may also include an internal display and/or external display with a user interface 76 for displaying data received by the communication interface 62 or any analysis performed by the processor 58. The resultant analog and/or digital signal may be transmitted to show on the internal display and/or external display with the user interface 76 (e.g., via the communication interface 62). Alternatively, the resultant signal could be sent to the workstation 64 via the communication interface 62. The steps or processes may, for example, be written in code and stored in the memory 60 to be executed by the processor 58 using, for instance, signal processing, analog-to-digital converters, or the like.

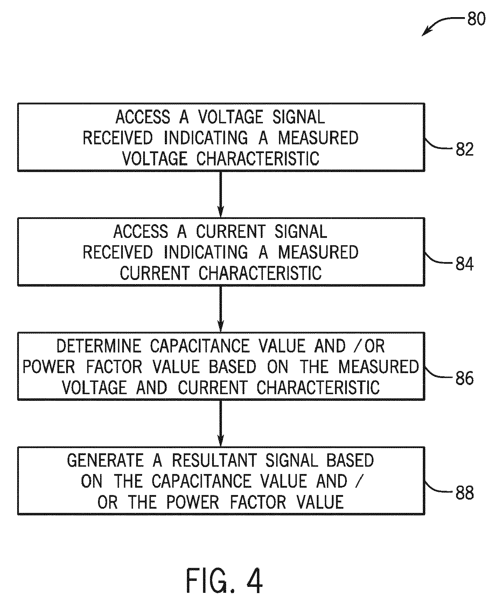

FIG. 4 is a process 80 performed by the bushing monitor 56 of FIG. 3. The process 80 may be included as code or instructions stored in a non-transitory computer-readable medium (e.g., the memory 60 of FIG. 3) and executed, for example, by the one or more processors 58 included in the bushing monitor 56.

The process 80 may begin by receiving signals from the voltage sensor 54 and/or the current sensor 52. The processor 58 may access the voltage signal received indicating a measured voltage characteristic (block 82). The measured voltage characteristic may be the voltage amplitude and/or phase. Similarly, the processor 58 may access the current signal received indicating a measured current characteristic (block 84). The processor 58 may then determine a capacitance value and/or power factor value based on the measured voltage and current characteristic (block 86).

The process 80 may continue by the processor 58 generating a resultant analog and/or digital signal based on the capacitance value and/or the power factor value (block 88). Further, the resultant signal may be based on a health assessment of the on-line bushing. As mentioned above, the processor 58 may perform other signal processing and data analysis regarding the on-line bushing 10. The health assessment may be based on the capacitance value, the power factor value, or other criteria like partial discharge, load, vibration, temperature, bushing age, or model. The resultant signal/output may indicate the capacitance value and/or the power factor value of the bushing.

Technical effects of the present embodiments relate to a bushing monitoring system that may be used to monitor the health of a bushing for a transformer. Specifically, the bushing monitor may generate and transmit signals to a workstation, internal, or external monitor indicating whether the bushing is healthy, the capacitance, the power factor, the dissipation factor, or any combination thereof. In certain embodiments, the bushing monitor may provide the above indications based on, for example, a measured voltage amplitude, measured voltage phase, measured current amplitude, or measured current phase from a voltage sensor and/or current sensor. The current sensor and or voltage sensor may be coupled to the transformer, the bushing, the test tap, the transmission line, or the like. In this way, the bushing monitoring system may substantially reduce the likelihood that a transformer will be damaged from the bushing, and, by extension, may reduce the possibility of power outages.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

**Claims**

1. A bushing system (10), comprising:

   a bushing monitor (56) configured to monitor on-line operation of a capacitive-core (14) bushing (10) with a test tap (16), wherein the bushing monitor comprises a processor (58) operatively coupled to a memory (60), wherein the processor (58) is configured to:

   access a voltage signal received indicating one of a measured voltage amplitude and/or a measured voltage phase (70) of the bushing (10);
   access a current signal received indicating one of a measured current amplitude and/or a phase (68) of the bushing (10);
   determine a capacitance value and/or power factor value (72) of the bushing (10) based on the measured voltage amplitude and the measured current amplitude or phase (68); and
   generate a resultant signal or output based on the capacitance value and/or the power factor value (72) of the capacitive-core bushing (14).

2. The bushing system of claim 1, comprising a voltage sensor (54) configured to transmit the voltage signal indicating the measured voltage amplitude and/or phase (70).

3. The bushing system of claim 2, comprising a case (53) configured to attach the voltage sensor (54) to a main lead of the capacitive-core bushing (14).

4. The bushing system of any of claims 1 to 3, wherein the capacitance value (72) is determined based on the measured current amplitude (68) divided by the measured voltage amplitude.

5. The bushing system of any of claims 1 to 4, comprising a current sensor (52) configured to transmit the measured current amplitude and/or phase (68) based on signals from the test tap (16) of the capacitive-core bushing (14).

6. The bushing system of any preceding claim, wherein the resultant signal comprises an analog signal, a digital signal, or any combination thereof.

7. The bushing system of any preceding claim, wherein the resultant signal is based on a health assessment of the capacitive-core bushing.

8. The bushing system of any preceding claim, wherein the bushing monitor (56) is configured to monitor a single bushing as the capacitive-core bushing (14).

9. The bushing system of any preceding claim, wherein the bushing monitor (56) is configured to determine the power factor value by using a single phase of a system.

10. The bushing system of any preceding claim, wherein the processor (58) is configured to determine the power factor value of the bushing (10) by determining the cosine of the angle between the measured voltage phase and the measured current phase.

11. The bushing system of claim 10, wherein the power factor value is related to the power factor, the dissipation factor, the angle between the measured voltage phase and the measured current phase, or any combination thereof of the bushing.

12. The bushing of any preceding claim, wherein the bushing monitor (56) comprises a communication interface (62) configured to transmit the resultant signal to a workstation (64).

13. A method, comprising:

accessing, via a processor (58), signals received from a voltage sensor (54) indicating a measured voltage amplitude and a measured voltage phase (70) of a bushing (10) during operation;
accessing, via the processor (58), signals from a current sensor (52) indicating a measured current amplitude and a measured current phase (68) of the bushing (10);
determining, via the processor (58), a capacitance value and a power factor value (72) of the bushing (10), wherein the capacitance value is based on the measured voltage amplitude and the measured current amplitude, wherein the power factor value is based on the measured voltage phase and the measured current phase; and
generating, via the processor (58), a resultant signal or output based on the capacitance value and the power factor value (72) of the bushing (10).

14. The method of claim 13, comprising dividing, via the processor (58), the measured current amplitude by the measured voltage amplitude to determine the capacitance value (72).

15. The method of claim 13 or 14, comprising determining, via the processor (54), an angle between the measured voltage phase and the measured current phase, wherein the power factor value (72) is based on the angle.

FIG. 1

FIG. 2

27

$I_C + I_R = I$

$V$   $I$

$I_R$   40

$R$   30

38   $I_C$

$C$   28

32

34   $\mathrm{II}$

$I_C$   44

$\delta$

42

$V$

38

$I_R$   40

$R$   36

FIG. 3

EP 3 056 913 A1

80

```
┌─────────────────────────────────────┐
│        ACCESS A VOLTAGE SIGNAL        │
│    RECEIVED INDICATING A MEASURED     │──── 82
│       VOLTAGE CHARACTERISTIC          │
└─────────────────────────────────────┘
                   │
                   ▼
┌─────────────────────────────────────┐
│        ACCESS A CURRENT SIGNAL        │
│    RECEIVED INDICATING A MEASURED     │──── 84
│       CURRENT CHARACTERISTIC          │
└─────────────────────────────────────┘
                   │
                   ▼
┌─────────────────────────────────────┐
│  DETERMINE CAPACITANCE VALUE AND /OR  │
│ POWER FACTOR VALUE BASED ON THE MEASURED │──── 86
│   VOLTAGE AND CURRENT CHARACTERISTIC  │
└─────────────────────────────────────┘
                   │
                   ▼
┌─────────────────────────────────────┐
│   GENERATE A RESULTANT SIGNAL BASED   │
│    ON THE CAPACITANCE VALUE AND /     │──── 88
│      OR THE POWER FACTOR VALUE        │
└─────────────────────────────────────┘
```

FIG. 4

Europäisches
Patentamt

European
Patent Office

Office européen
des brevets

# EUROPEAN SEARCH REPORT

Application Number

EP 16 15 0588

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 757 263 A (CUMMINGS III HAROLD B [US] ET AL) 12 July 1988 (1988-07-12)<br>* column 1, line 29 - line 34 *<br>* column 1, line 42 - line 60 *<br>* column 4, line 18 - line 21 *<br>* column 4, line 41 - line 44 *<br>* column 4, line 49 - line 52 *<br>* column 6, line 65 - line 68 *<br>* column 7, line 27 - line 37 *<br>* column 16, line 3 - line 20 *<br>* column 16, line 5 - line 7 *<br>* column 25, line 45 - line 61 *<br>* column 26, line 3 - line 19 *<br>* column 26, line 36 - line 54 *<br>* figure 1 *<br>* column 5, line 62 - line 64 *<br>* column 5, line 1 - line 7 *<br>* column 3, line 22 - line 31 *<br>* column 16, line 45 - line 51 *<br>----- | 1-15 | INV.<br>G01R21/00<br>G01R27/26<br>G01R31/12 |
| X | YAN ZHANG ET AL: "ON-SITE AUTOMATIC MEASUREMENT OF HV INSULATION", PROCEEDINGS OF THE INTERNATIONAL CONFERENCE ON PROPERTIES AND APPLICATIONS OF DIELECTRIC MATERIALS. BEIJING, SEPT. 12 - 16, 1988; [PROCEEDINGS OF THE INTERNATIONAL CONFERENCE ON PROPERTIES AND APPLICATIONS OF DIELECTRIC MATERIALS], NEW YORK, IEEE, US,<br>vol. 2, 12 September 1988 (1988-09-12), pages 642-644, XP000075923,<br>* the whole document *<br>----- | 1,2,5,7,8,11,12 | **TECHNICAL FIELDS SEARCHED (IPC)**<br><br>G01R |

-/--

The present search report has been drawn up for all claims

| Place of search | Date of completion of the search | Examiner |
|---|---|---|
| Munich | 8 June 2016 | Danisi, Alessandro |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 16 15 0588

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 1 338 445 A (DOBLE ENG CO) 21 November 1973 (1973-11-21) * page 1, line 13 - line 14 * * page 2, line 10 - line 43 * * page 2, line 71 - line 81 * * page 3, line 95 - line 102 * * page 4, line 1 - line 12 * * page 4, line 83 - page 5, line 26 * * figures 1-3 * ----- | 1-15 | |
| A | US 2010/097076 A1 (SANTOS EDUARDO PEDROSA [BR]) 22 April 2010 (2010-04-22) * the whole document * ----- | 1-15 | |
| A | US 2005/218906 A1 (YOUNSI ABDELKRIM K [US] ET AL) 6 October 2005 (2005-10-06) * the whole document * ----- | 1-15 | |

TECHNICAL FIELDS
SEARCHED      (IPC)

The present search report has been drawn up for all claims

| Place of search | Date of completion of the search | Examiner |
|---|---|---|
| Munich | 8 June 2016 | Danisi, Alessandro |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 16 15 0588

This annex lists the patent family members relating to the patent documents cited in the above-mentioned European search report.
The members are as contained in the European Patent Office EDP file on
The European Patent Office is in no way liable for these particulars which are merely given for the purpose of information.

08-06-2016

| Patent document cited in search report | | Publication date | Patent family member(s) | | Publication date |
|---|---|---|---|---|---|
| US 4757263 | A | 12-07-1988 | NONE | | |
| GB 1338445 | A | 21-11-1973 | CA | 939747 A | 08-01-1974 |
| | | | GB | 1338445 A | 21-11-1973 |
| US 2010097076 | A1 | 22-04-2010 | BR | PI0700841 A | 04-11-2008 |
| | | | EP | 2135099 A2 | 23-12-2009 |
| | | | US | 2010097076 A1 | 22-04-2010 |
| | | | WO | 2008113142 A2 | 25-09-2008 |
| US 2005218906 | A1 | 06-10-2005 | NONE | | |

EPO FORM P0459

For more details about this annex : see Official Journal of the European Patent Office, No. 12/82